# EUROPÄISCHE PATENTSCHRIFT

(11) **EP 0 801 144 B1**
(45) Veröffentlichungstag und Bekanntmachung des Hinweises auf die Patenterteilung: **16.05.2001**
(21) Anmeldenummer: 97103889.8
(22) Anmeldetag: 07.03.1997
(51) Int. Cl.: C23C 14/06, C23C 16/02, C23C 14/02, C23C 16/30, C23C 30/00

(54) **Bauteil mit Verschleissschutzschicht und Verfahren zu dessen Herstellung**
Element with a wear resistant layer, and process for the manufacture of such an element
Objet pourvu d'un revêtement résistant à l'usure et procédé d'obtention

(30) Priorität: 12.04.1996 DE 19614557
(43) Veröffentlichungstag der Anmeldung: 15.10.1997
(73) Patentinhaber: HAUZER TECHNO COATING EUROPE BV, 5902 RB Venlo (NL)
(72) Erfinder: Fleischer, Werner, Dr.-Ing., 5988 KG Helden (NL); Hurkmans, Antonius P.A., 5862 AE Geijsteren (NL)
(74) Vertreter: Schmidt, Christian, Dipl.-Phys.

(56) Entgegenhaltungen:
- WO-A-97/04142
- CA-A- 868 514
- US-A- 3 857 682
- US-A- 5 282 985
- DATABASE WPI Section Ch, Week 8247 Derwent Publications Ltd., London, GB; Class L02, AN 82-01332J XP002035723 & JP 57 169 080 A (TOSHIBA TUNGALLOY KK) , 18.Oktober 1982
- PATENT ABSTRACTS OF JAPAN vol. 013, no. 368 (P-919), 16.August 1989 & JP 01 124116 A (NEC CORP), 17.Mai 1989,
- PATENT ABSTRACTS OF JAPAN vol. 007, no. 093 (P-192), 19.April 1983 & JP 58 019739 A (SONY KK), 4.Februar 1983,
- PATENT ABSTRACTS OF JAPAN vol. 018, no. 052 (C-1158), 27.Januar 1994 & JP 05 271675 A (MITSUBISHI HEAVY IND LTD), 19.Oktober 1993,
- PATENT ABSTRACTS OF JAPAN vol. 001, no. 029 (C-010), 28.März 1977 & JP 51 147485 A (FUJITSU LTD), 17.Dezember 1976,
- PATENT ABSTRACTS OF JAPAN vol. 015, no. 154 (C-0825), 18.April 1991 & JP 03 031472 A (OLYMPUS OPTICAL CO LTD), 12.Februar 1991,
- SURFACE AND COATINGS TECHNOLOGY, 24 JULY 1992, SWITZERLAND, Bd. 53, Nr. 1, ISSN 0257-8972, Seiten 13-23, XP002036184 HILTON M R ET AL: "Structural and tribological studies of MoS/sub 2/ solid lubricant films having tailored metal-multilayer nanostructures"

## Beschreibung

Die Erfindung betrifft ein Verfahren zur Herstellung eines Bauteils mit einer Einlagen- oder Mehrlagenhartstoffschicht und einer Verschleißschicht.

Es ist bereits bekannt, durch das Aufbringen von Verschleißschutzschichten auf Schneidwerkzeugen das Verschleißverhalten und die Korrosionsbeständigkeit dieser Werkzeuge zu verbessern und dadurch ihre Lebensdauer zu verlängern. Als Verschleißschutzschichten kommen in den letzten Jahren vermehrt Hartstoffschichten aus Nitriden, Karbiden oder Karbonitriden zum Einsatz, die als Metallkomponenten Ti, Cr, TiAl oder Zr enthalten und üblicherweise in einem PVD- oder CVD-Prozeß hergestellt werden. Ferner sind mehrlagige Verschleißschutzschichten aus unterschiedlicher Hartstoffschichten bekannt, die gegenüber Einlagenschichten günstigere Verschleißeigenschaften aufweisen können.

Es hat sich jedoch gezeigt, daß diese bekannten Hartstoffschichten keine befriedigenden Antihafteigenschaften gegenüber Kunststoffen und auch anderen Materialien zeigen. Wenngleich dies in manchen Einsatzbereichen, z.B. bei Schneidwerkzeugen für die Metallbearbeitung, keine besondere Rolle spielt, sind bei Bauteilen, die im Bereich der Herstellung und Bearbeitung von Kunststoffen eingesetzt werden - beispielsweise Formen oder Extrusionswerkzeugen - günstige Antihafteigenschaften gegenüber Kunststoffen von wesentlicher Bedeutung. Gleiches gilt für Anwendungsbereiche im Maschinenbau, wenn Verschleißflächen unter Belastungsbedingungen mit Kunststofflächen in pressendem oder gleitendem Kontakt stehen, wie dies beispielsweise bei Stütz- oder Lagerelementen der Fall ist.

Es ist bereits bekannt, zur Verbesserung der Antihafteigenschaften einer galvanisch abgeschiedenen Chromschicht Teflon in die Schicht einzulagern. Dabei stellt sich als nachteilig heraus, daß die Teflonpartikel im Belastungsfall vergleichsweise schnell aus der Chromschicht ausgewaschen werden, was zu einer allmählichen Verschlechterung der Antihaftwirkung der Schicht führt. Außerdem weist eine solche Chromschicht, selbst wenn Hartchrom verwendet wird, nicht die in der Praxis für viele Anwendungsfälle geforderte Verschleißfestigkeit auf, da es sich bei Hartchrom nicht um einen Hartstoff gemäß der eingangs angegebenen Definition handelt.

Die Aufgabe der Erfindung besteht darin, ein Verfahren der eingangs angegebenen Art so auszugestalten, daß einem Bauteil sowohl eine hohe Verschleißbeständigkeit als auch ein günstiges Antihaftverhalten gegen Kunststoffe verliehen werden kann und hochqualitative, an spezielle Bedarfssituationen angepaßte Verschleißschutzschichten hergestellt werden können.

Diese Aufgabe wird durch die Merkmale des Patentanspruchs 1 gelöst.

Ein nach dem erfindungsgemäßen Verfahren hergestellter Verbund von Hartstoffschichten und Mischschicht besitzt im Vergleich zu herkömmlichen Hartstoffschichten um Größenordnungen verbesserte Antihaftwirkung gegenüber Kunststoffen bei Beibehaltung der für Hartstoffschichten typischen hohen Verschleißfestigkeiten.

Vorzugsweise besteht die Hartstoffkomponente aus einem oder mehreren der Materialien TiCN, CrN, CrCN, ZrN und TiAlN.

Besonders vorteilhafte Antifhafteigenschaften werden mit einer unipolaren Materialkomponente aus MOS₂ erzielt, insbesondere dann, wenn diese 10 bis 65 Gew.-% der Verschleißschutzschicht ausmacht.

In einer bevorzugten Ausführungsform der vorliegenden Erfindung ist die Verschleißschutzschicht als Dreilagenschicht aufgebaut, wobei die auf dem Bauteil aufliegende Lage aus CrN, die darüberliegende Lage aus CrCN und die oberste Mischschicht-Lage aus den Komponenten CrCN und MoS₂ besteht.

Bei einer bevorzugten Ausführungsform der Erfindung ist der Anteil der unipolaren Materialkomponente über die Mischschichtdicke konstant, wodurch über die Mischschichtdicke gleichbleibende Verschleiß- und Antihafteigenschaften erhalten werden. Genausogut kann vorgesehen sein, daß der Anteil der unipolaren Materialkomponente über die Mischschichtdicke variiert. Dadurch wird eine sogenannte Gradientenmischschicht geschaffen, die im Laufe ihrer Abnutzung ein sich änderndes Verschleiß- bzw. Antifhaftverhalten zeigt. Durch eine geeignete Verteilung der unipolaren Materialkomponente über die Schichtdicke lassen sich Gradientenmischschichten mit speziell an unterschiedliche Anwendungsfälle angepaßten Eigenschaften herstellen.

Eine weitere Ausführungsform der Erfindung kennzeichnet sich dadurch, daß die MOS₂-Komponente als Vielschichtsystem in Superlatticestruktur in die Verschleißschutzschicht eingelagert ist und die Einzelmischschichtdicken dieser Struktur im Bereich von 10 bis 200 nm liegen.

Allen Ausführungsformen der Erfindung ist gemeinsam, daß durch die unipolare Wirkung der Materialkomponente im Belastungsfall unerwünschte Klebewirkungen sowie Belagbildungen am Bauteil reduziert und ggf. vollständig vermieden werden können.

Durch die Anwendung eines PVD-Vakuum-Abscheideverfahrens wird ermöglicht, daß die Partikelgrößen der beiden Mischschichtkomponenten in einer Größenordnung liegen, bei der ein homogener, hochfester Schichtverbund entsteht. Dies hat zur Folge, daß eine unerwünschte Auswaschung der unipolaren Materialkomponente unter Belastung weitgehend ausgeschlossen ist. Da das bei dem erfindungsgemäßen Herstellungsverfahren zum Einsatz kommende PVD-Abscheideverfahren eine extrem genaue Überwachung des Schichtbildungsprozesses ermöglicht, sind Verschleißschutzschichten mit gleichbleibend hoher Qualität und geringem Verunreinigungsgrad herstellbar.

Wenn die Hartstoffkomponente und die unipolare Materialkomponente beim Beschichtungsprozeß mittels separater Quellen, insbesondere mittels ArC-, Sputter-, Elektronenstrahl- oder thermischen Verdampfungsquellen abgeschieden werden, ist der Aufbau bzw. die Zusammensetzung der Verschleißschutzschicht während des Beschichtungsprozesses durch Regelung der Quellenintensitäten in vorteilhafter Weise frei einstellbar. In diesem Fall kennzeichnet sich ein erster bevorzugter Verfahrensablauf dadurch, daß in einer ersten Phase des Beschichtungsprozesses ohne Beteiligung der unipolaren Materialkomponente eine oder mehrere Hartstoffschichtlagen auf dem Bauteil aufgebracht werden und daß die unipolare Materialkomponente erst in einer späteren zweiten Phase dem Beschichtungsprozeß zum Aufbau der Mischschicht hinzugefügt wird.

Ein weiterer vorteilhafter Verfahrensablauf zeichnet sich dadurch aus, daß bei gleichzeitigem Betrieb der Hartstoffkomponentenquelle und der Materialkomponentenquelle durch eine vorgegebene zeitliche Regelung der Quellenintensität(en) die Zusammensetzung der sich aufbauenden Mischschicht in Abhängigkeit von ihrer Schichtdicke nach Wunsch eingestellt wird. Insbesondere kann es zweckmäßig sein, die Intensität der Hartstoffkomponentenquelle zeitlich so zu regeln, daß die Mischschicht einen mit zunehmender Schichtdicke ansteigenden unipolaren Materialkomponentenanteil aufweist.

Weitere vorteilhafte Verfahrensschritte der Erfindung sind in Unteransprüchen angegeben.

Die Erfindung wird nachfolgend anhand von Ausführungsbeispielen unter Bezugnahme auf die Zeichnung erläutert; in der Zeichnung zeigt:
- Fig. 1: eine schematische Querschnittdarstellung eines Oberflächenbereichs des erfindungsgemäßen Bauteils mit mehrlagiger Verschleißschutzschicht,
- Fig. 2: ein Diagramm, in dem die prozentualen Anteile der Komponenten einer Mischschicht in Abhängigkeit von der Schichtdicke angegeben sind, und
- Fig. 3: eine schematische Darstellung einer Vakuumkammer zur Durchführung des erfindungsgemäßen Verfahrens in Draufsicht.

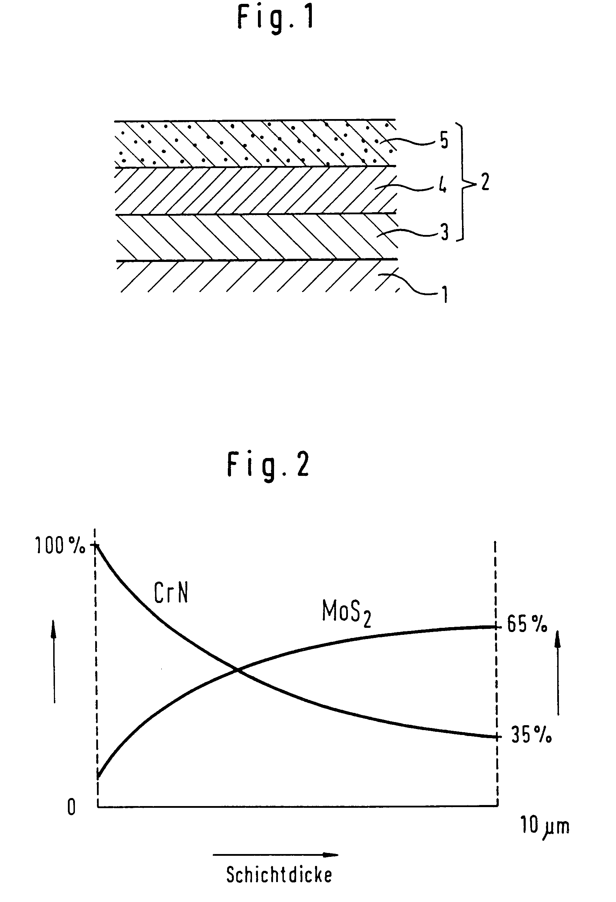

Nach Fig. 1 besteht eine erste Ausführungsform des erfindungsgemäßen Bauteils mit Verschleißschutzschicht aus einem Bauteilkörper 1, auf dessen Oberfläche eine dreilagige Verschleißschutzschicht 2 aufgebaut ist. Die dreilagige Verschleißschutzschicht 2 besteht aus einer ersten Hartstoffträgerschicht 3 aus CrN, einer darüberliegenden Hartstoffträgerschicht 4 aus CrCN sowie einer oberen Mischschicht 5, die aus dem Hartstoff CrCN und dem unipolaren Material MoS₂ gebildet ist. Die Schichtdicken der Einzelschichten 3, 4, 5 liegen typischerweise in der Größenordnung von etwa 1 bis 15µm.

Mit dem in Fig. 1 dargestellten Schichtaufbau wurde bei einer Gesamtdicke der beiden Hartstoffträgerschichten 3 und 4 im Bereich von 3 bis 10 *µ* m und einer Dicke der Mischschicht 5 von 5 *µ*m ein Scratchwert mit einer kritischen Last von 40 N und einer Mikrohärte von HV=1900 erzielt, wobei der MoS₂-Anteil in der Mischschicht 5 etwa 25% betrug und über die Dicke der Mischschicht 5 konstant war.

Bei einem zweiten, nicht dargestellten Ausführungsbeispiel der Erfindung ist die Verschleißschutzschicht 2 als einlagige, aus den Komponenten CrN und MoS₂ bestehende Mischschicht aufgebaut.

Bei einer Schichtdicke von 10 *µ*m und einem gemäß Fig. 2 mit wachsender Schichtdicke von 10% auf etwa 65% ansteigenden MoS₂/CrN Verhältnis zeigt dieses Ausführungsbeispiel einen gegenüber dem ersten Beispiel verbesserten kritischen Lastwert von 55 N, wobei die Mikrohärte dieser sogenannten Gradientenschicht trotz des hohen Anteils von MoS₂ im Bereich der Schichtoberfläche noch den vergleichsweise hohen Wert von HV=1750 aufweist.

Selbstverständlich kann auch bei dem ersten Ausführungsbeispiel nach Fig. 1 die obere Mischschicht 5 als Gradientenschicht gemäß dem zweiten Ausführungsbeispiel ausgebildet sein, und es ist ohne weiteres möglich, Gradientenschichten aus anderen Materialpartnern und mit anderen Verteilungsverläufen als den in Fig. 2 angegebenen zu bilden.

Der Bauteilkörper 1 bzw. Werkzeug kann beispielsweise aus einem Kalt- oder Warmarbeitsstahl, Messing, Cu- oder eine Al-Legierung bestehen.

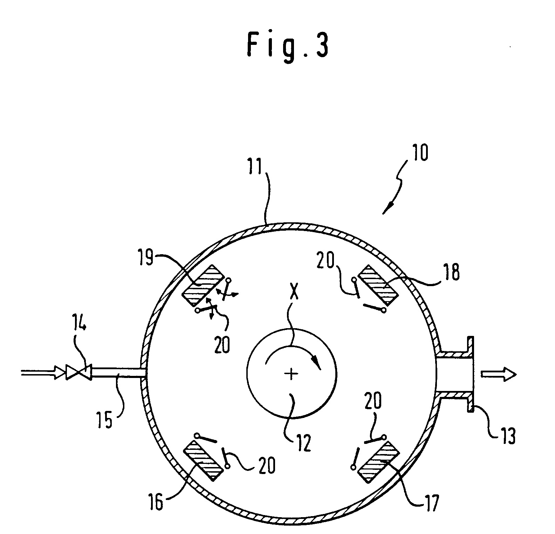

Im folgenden wird eine Ausgestaltung des erfindungsgemäßen Verfahrens unter Bezugnahme auf die in Fig. 3 dargestellte Beschichtungsanlage 10 beschrieben.

Die Beschichtungsanlage 10 besteht aus einer Vakuumkammer 11, in deren Zentrum sich das Bauteil 12 befindet und dort gemäß Pfeil X drehbar gelagert ist. Der Drehantrieb des Bauteils 12 kann beispielsweise über einen außerhalb der Vakuumkammer 11 angeordneten, nicht dargestellten Elektromotor erfolgen.

Die Vakuumkammer 11 ist über einen Flansch 13 an ein in Fig. 3 nicht dargestelltes Vakuumpumpsystem angeschlossen und kann über eine mit einem oder mehreren Regelventilen 14 versehene Zuführung 15 in kontrollierbarer Weise mit einem oder mehreren Reaktivgasen und ggf. weiteren Gasen dosiert werden.

Ferner sind in der Vakuumkammer 11 vier auf das zentrale Bauteil 12 gerichtete Materialquellen 16, 17, 18, 19 untergebracht, wobei es sich bei den Quellen 16, 18 um Hartstoffbeschichtungsquellen und den Quellen 17, 19 um Quellen zur Beschichtung des Bauteils 12 mit der unipolaren Materialkomponente handelt. Die Hartstoffbeschichtungsquellen 16, 18, bei denen es sich beispielweise um ArC oder Sputterquellen handelt, sind beispielsweise mit einem Cr-Target versehen, und die Quellen 17, 19 für die unipolare Materialkomponente sind HF-Sputterquellen mit beispielsweise einem MoS₂-Target. Jede Quelle 16, 17, 18, 19 weist eine Blendenanordnung 20 auf, mittels der das Bauteil 12 gegenüber der Quelle abgeschirmt werden kann.

Das erfindungsgemäße Verfahren wird nachfolgend anhand des Verfahrensablaufs zur Herstellung des Bauteils nach dem ersten Ausführungsbeispiel erläutert.

In einer ersten Beschichtungsphase werden die in Fig. 1 dargestellten Hartstoffträgerschichten 3 und 4 auf das Bauteil 12 aufgebracht. Dies erfolgt durch Aktivierung der Hartstoffquellen 16, 18 und unter Zugabe eines oder mehrerer geeigneter Reaktivgase, beispielsweise N₂ bzw. eines Kohlenwasserstoffes. Während der ersten Beschichtungsphase bleiben die Blenden 20 der MoS₂-Quellen 17, 19 geschlossen. Nach Erreichen der vorgesehenen Schichtdicken des Hartstoffträgersystems 3, 4 werden die MoS₂-Quellen 17, 19 durch Öffnung ihrer Blenden 20 zugeschaltet. Die Zusammensetzung der sich nun aufbauenden Mischschicht 5 aus CrCN und MoS₂ wird über die Quellenströme gesteuert. Ferner wird durch eine Regelung der Bauteiltemperatur eine Überschreitung der höchstzulässigen Materialtemperatur verhindert, wodurch ein Härteverlust bzw. eine Verdampfung von Materialkomponenten des Substrats ins Vakuum verhindert wird.

Zusammenfassend ist feststellen, daß nach der Erfindung Verschleißschutzschichten herstellbar sind, die bei Beibehaltung der bekannt hohen Verschleißfestigkeit von Hartstoffschichten eine verbesserte Antihaftwirkung gegenüber Kunststoffen aufweisen, wobei ein wesentlicher Aspekt der Erfindung darin zu sehen ist, daß mittels des erfindungsgemäßen Herstellungsverfahren ein besonders gut kontrollierbares, gleichmäßiges Schichtwachstum ermöglicht wird, was einerseits für die Qualität der hergestellten Mischschicht in bezug auf Härte- und Antihafteigenschaften von wesentlicher Bedeutung ist und andererseits die gezielte Herstellung von mit speziellen Eigenschaften ausgestatteten, "maßgeschneiderten" Schichten ermöglicht.

## Patentansprüche

1. Verfahren zur Herstellung eines Bauteils oder Werkzeugs mit einer mittels eines PVD-Verfahrens auf das jeweilige Substrat aufgebrachten Ein- oder Mehrlagenhartstoffschicht und einer Verschleißschutzschicht,
dadurch **gekennzeichnet**,
daß zunächst zumindest eine Hartstoffkomponentenschicht (3, 4) aus TiCN und/oder CrN und/oder CrCN und/oder ZrN und/oder TiALN auf dem Substrat abgeschieden und anschließend zur Bildung der Verschleißschutzschicht (2) zumindest eine Mischschicht durch gleichzeitige Abscheidung zumindest einer der Komponenten der Hartstoffkomponentenschicht und einer unipolaren Materialkomponente mit Antihaftwirkung gegenüber Kunststoffen auf die Hartstoffkomponentenschicht (3, 4) aufgebracht wird.

2. Verfahren nach Anspruch 1,
dadurch **gekennzeichnet**,
daß als unipolare Materialkomponente MoS₂ verwendet wird.

3. Verfahren nach Anspruch 2,
dadurch **gekennzeichnet**,
daß der Anteil der unipolaren Materialkomponente im Bereich von 10 bis 65 Gew.-% der Mischschicht gewählt wird.

4. Verfahren nach Anspruch 1,
dadurch **gekennzeichnet**,
daß auf das Substrat (1) zunächst eine Lage (3) aus CrN, dann auf diese Lage eine weitere Lage (4) aus CrCN und darauffolgend eine Mischschicht-Lage (5) aus CrCN und MoS₂ aufgebracht wird.

5. Verfahren nach einem der vorhergehenden Ansprüche,
dadurch **gekennzeichnet**,
daß bei der Aufbringung der Mischschicht der Anteil der unipolaren Materialkomponente über die Mischschichtdicke konstant gehalten wird.

6. Verfahren nach einem der Ansprüche 1 bis 4,
dadurch **gekennzeichnet**,
daß bei der Aufbringung der Mischschicht (5) der Anteil der unipolaren Materialkomponente über die Schichtdicke variiert und insbesondere mit zunehmender Schichtdicke erhöht wird.

7. Verfahren nach einem der vorhergehenden Ansprüche,
dadurch **gekennzeichnet**,
daß die unipolare Materialkomponente als Vielschichtsystem in Superlatticestruktur in die Verschleißschutzschicht eingelagert und die Einzelmischschichtdicken dieses Systems im Bereich von 10 bis 200 nm gewählt werden.

8. Verfahren nach einem der vorhergehenden Ansprüche,
dadurch **gekennzeichnet**,
daß die verschiedenen Komponenten im PVD-Verfahren unter Verwendung individueller Quellen aufgebracht werden und bei gleichzeitigem Betrieb der Hartstoffkomponentenquelle und der Materialkomponentenquelle durch eine zeitliche Regelung der Quellenintensität oder der Quellenintensitäten die Zusammensetzung der sich aufbauenden Mischschicht (5) in Abhängigkeit von ihrer Schichtdikke eingestellt wird.

9. Verfahren nach Anspruch 8,
dadurch **gekennzeichnet**,
daß die Intensität der Hartstoffkomponentenquelle zeitlich so geregelt wird, daß die Mischschicht (5) einen mit zunehmender Schichtdicke ansteigenden Anteil der unipolaren Materialkomponente aufweist.

10. Verfahren nach einem der vorhergehenden Ansprüche,
dadurch **gekennzeichnet**,
daß durch eine Regelung der Bauteiltemperatur eine Überschreitung der höchstzulässigen Materialtemperatur während des Beschichtungsprozesses verhindert wird.

## Claims

1. A method for manufacturing a component or a tool having a single layer or multilayer hard material coating and a wear protection layer applied to the respective substrate by means of a PVD process, characterised in that at least one hard material component layer (3, 4) of TiCN and/or CrN and/or CrCN and/or ZrN and/or TiAlN is initially deposited on the substrate and subsequently at least one mixed layer is applied to the hard material component layer (3, 4) to form the wear protection layer (2) by the simultaneous deposition of at least one of the components of the hard material component layer and a unipolar material component with an anti-adhesion effect with respect to plastics.

2. A method in accordance with claim 1, characterised in that MoS₂ is used as the unipolar material component.

3. A method in accordance with claim 2, characterised in that the proportion of the unipolar material component is selected in the region from 10 to 65% by weight of the mixed layer.

4. A method in accordance with claim 1, characterised in that initially a film (3) of CrN is applied to the substrate (1) and then a further film (4) of CrCN to this film and subsequently a mixed layer film (5) of CrN and MoS₂.

5. A method in accordance with any one of the preceding claims, characterised in that the proportion of the unipolar material component is kept constant over the mixed layer thickness during the application of the mixed layer.

6. A method in accordance with any one of claims 1 to 4, characterised in that the proportion of the unipolar material component is varied over the layer thickness and is in particular increased as the layer thickness increases during the application of the mixed layer (5).

7. A method in accordance with any one of the preceding claims, characterised in that the unipolar material component is deposited in the wear protection layer as a multi-layer system in a super-lattice structure and in that the single mixed layer thicknesses of this system are selected in the range from 10 to 200 nm.

8. A method in accordance with any one of the preceding claims, characterised in that the different components are applied in the PVD process using individual sources and in that the composition of the mixed layer (5) which builds up with a simultaneous operation of the hard material component source and the material component source is adjusted in dependence on its layer thickness by a time regulation of the source intensity or the source intensities.

9. A method in accordance with claim 8, characterised in that the intensity of the hard material component source is time-regulated such that the mixed layer (5) has a proportion of the unipolar material component which increases as the layer thickness increases.

10. A method in accordance with one of the preceding claims, characterised in that a regulation of the component temperature prevents the maximum permitted material temperature being exceeded during the coating process.

## Revendications

1. Procédé de fabrication d'un composant ou d'un outil avec un revêtement de substance dure monocouche ou multicouche appliqué au moyen d'un procédé de PVD sur le substrat correspondant et une couche de protection contre l'usure,
caractérisé en ce qu'on dépose d'abord au moins une couche (3, 4) de composants d'une substance dure en TiCN et/ou CrN et/ou CrCN et/ou ZrN et/ou TiAlN sur le substrat et ensuite, pour la formation de la couche (2) de protection contre l'usure, on applique au moins une couche mixte, par dépôt simultané d'au moins l'un des composants de la couche de composants d'une substance dure et d'un composant d'une matière unipolaire ayant un effet anti-adhésif vis-à-vis des matières plastiques, sur la couche (3, 4) de composants d'une substance dure.

2. Procédé selon la revendication 1,
caractérisé en ce qu'on utilise du MoS₂ comme composant d'une matière unipolaire.

3. Procédé selon la revendication 2,
caractérisé en ce qu'on choisit la proportion du composant d'une matière unipolaire dans la plage de 10 à 65 % en poids par rapport à la couche mixte.

4. Procédé selon la revendication 1,
caractérisé en ce qu'on applique, sur le substrat (1), d'abord une couche (3) de CrN, ensuite on applique, sur cette couche, une couche supplémentaire (4) de CrCN, et on applique sur celle-ci une couche mixte (5) de CrCN et de MoS₂.

5. Procédé selon l'une des revendications précédentes,
caractérisé en ce que, pour l'application de la couche mixte, la proportion du composant d'une matière unipolaire est maintenue constante sur toute l'épaisseur de la couche mixte.

6. Procédé selon l'une des revendications 1 à 4,
caractérisé en ce que, pour l'application de la couche mixte (5), on fait varier la proportion du composant d'une matière unipolaire sur l'épaisseur de la couche, et en particulier, on l'augmente quand l'épaisseur de la couche augmente.

7. Procédé selon l'une des revendications précédentes,
caractérisé en ce qu'on insère le composant d'une matière unipolaire en tant que système multicouche dans une structure de super-réseau dans la couche de protection contre l'usure et on choisit les épaisseurs des couches mixtes individuelles de ce système dans la plage de 10 à 200 nm.

8. Procédé selon l'une des revendications précédentes,
caractérisé en ce qu'on applique les différents composants dans le procédé de PVD en utilisant des sources individuelles, et par actionnement simultané de la source de composants d'une substance dure et de la source de composants d'une matière au moyen d'un réglage dans le temps de l'intensité de la source ou des intensités des sources, on ajuste la composition de la couche mixte (5) qui se constitue en fonction de son épaisseur.

9. Procédé selon la revendication 8,
caractérisé en ce qu'on règle l'intensité de la source de composants d'une substance dure de façon à ce que la couche mixte (5) présente une proportion croissante de composant d'une matière unipolaire quand l'épaisseur de la couche augmente.

10. Procédé selon l'une des revendications précédentes,
caractérisé en ce que, grâce à une régulation de la température du composant, on empêche un dépassement de la température maximale autorisée de la matière pendant le procédé de revêtement.
